# EUROPEAN PATENT APPLICATION

(11) **EP 3 197 071 A1**
(43) Date of publication of application: **26.07.2017**
(21) Application number: 17154389.5
(22) Date of filing: 29.04.2004
(51) Int. Cl.: H04B 7/185, H05K 9/00, B64C 1/14

(54) **WIRELESS COMMUNICATION INSIDE SHIELDED ENVELOPE**

(30) Priority: 12.05.2003 US 435785
(62) Divisional of application: 04010148.7
(71) Applicant: The Boeing Company, Chicago, IL 60606-1596 (US)
(72) Inventor: DE LA CHAPELLE, Michael, Bellevue, WA 98008 (US); BOGART, David W., Renton, WA 98056 (US)
(74) Representative: Witte, Weller & Partner Patentanwälte mbB

(57) **Abstract**

A system and method limit transmission of wireless electromagnetic device radiation (66) through the windows (16, 20) of a mobile platform outer envelope (14). A shielding layer (18) is applied to the window (16, 20) and electrically grounded to the outer envelope (14). At least one transceiver hub (24, 34) is located within the mobile platform (12) receiving and/or transmitting the electromagnetic device radiation (66). An off-board communication device (46) wirelessly communicates with the transceiver hub (24, 34). The shielding layer (18) attenuates a portion of the radiation contacting the window. Only a communication path between the transceiver hub (24, 34) and the off-board communication device (46) is therefore operable (Fig. 1).

## Description

### FIELD OF THE INVENTION

The present invention relates in general to wireless communication devices and more specifically to a device and method to limit wireless communication device transmission and reception.

### BACKGROUND OF THE INVENTION

The use of personal wireless devices such as cellular phones, notebook computers and personal digital assistants for operation on mobile platforms, hereinafter generally referred to as aircraft, creates several problems. One problem is that cellular (cell) phone handsets onboard aircraft at cruise elevation (e.g., approximately 10,668 m ((35,000 ft.)) have line-of-sight visibility for approximately 426 km (265 miles) in all directions. This area can encompass tens, hundreds, or even thousands of cell phone base stations, causing interference and reducing the system capacity over a vast area. A single cell phone call at 10,668 m can use spectral resources equivalent to tens, hundreds, or thousands of terrestrial cell phone calls.

A second problem is that the ability of the handset to simultaneously connect to large numbers of base stations also degrades the transport and switching infrastructure of the terrestrial carrier. The mobile switching center (MSC) and base station controllers assign subscribers to base stations. Common MSC and base station controllers are not designed to hand off calls, of relatively equal signal strength, between large numbers of base stations. Rapid movement of the handset, i.e., while on a mobile platform, can cause the received signal strength at the base stations to change, causing the cell phone call to be handed off between base stations. The cell phone handsets are also unable to track this large number of base stations. This can result in ping-ponging of the attachment point (base station) in the network and cause significant resource allocations to this one call.

Another problem with cell phone usage aboard aircraft in flight is potential interference with onboard flight critical navigation and communication systems. Radio frequency (RF) radiation emitted from cell phones or other wireless devices can escape the fuselage of the aircraft through the window openings and propagate along the skin of the aircraft where the signals can impinge on the external antennas used for flight critical functions. The problem can be exacerbated by common wireless communication protocols that command the cell phone handset to increase its transmit power level to establish and maintain communication with terrestrial base stations. The long path distance and the signal attenuation introduced by the metallic fuselage usually cause the cell phone to operate at elevated power levels when communicating with base stations outside the fuselage of the aircraft, increasing the potential to interfere with on-board electronic equipment and increasing the potential RF exposure to passengers.

Picocell antennas have been deployed in confined spaces such as buildings and rooms to allow occupants to communicate using cellular phones and wireless computing devices. This type of equipment has also had very limited deployment inside aircraft cabins. One major technical problem is that there is no guarantee that passengers using mobile phones on aircraft will connect to a picocell within the aircraft. If a higher signal strength is measured by the passengers' hand set receiver to an external cell tower (base station) rather than the internal picocell, cell phones can connect to the external tower. This scenario can often occur when a passenger is seated near a window of the aircraft and the base station is relatively close to the aircraft. It is also impractical to establish onboard picocells for every global variant of cell phone standards and frequency (i.e., GSM, GPRS, EDGE, iDEN, CDMA, JCDMA, TDMA, AMPS, 3G, etc.). A commercial aircraft will therefore generally offer only one or two, or a small subset of all of the cell phone standards used by passenger phones, It is therefore difficult to allow only the wireless services that are supported by onboard picocells while excluding all others. It is unreasonable to expect the flight crews of commercial airlines to police the cell phone usage of their passengers in order to assure all non-supported cellular technologies are sufficiently attenuated from interfering with terrestrial networks.

It is therefore desirable to provide a system and method to limit all off-board connectivity (to terrestrial base stations) of passenger wireless devices which are not supported by the aircraft's on-board picocells, or wireless access points, without the use of jamming devices that have been prohibited by the FCC and which add RF emissions inside the mobile platform.

### SUMMARY OF THE INVENTION

A system is provided which limits transmission of radio frequency (RF) energy emitted from personal wireless devices (e.g. cell phones, computers, etc.) through an outer envelope of a mobile platform. The system includes a mobile platform having at least one window opening through the outer envelope. A transparent electromagnetic shielding layer is applied to the surface of the window and electrically grounded to the outer envelope. The shielding layer attenuates enough of the radiated RF energy from personal wireless devices within the envelope such that direct communication with a terrestrial base station through the window openings is substantially prevented.

At least one RF transceiver is disposed within the shielded envelope of the mobile platform that communicates with at least one of the personal wireless devices. An off-board communication antenna is located outside the shielded envelope to provide communication between the mobile platform and the ground. The RF transceiver within the envelope is connected to the off-board communication antenna located outside the shielded envelope to allow the personal wireless devices to communicate between the mobile platform and the ground. Therefore, the invention provides another path for personal wireless devices to communicate outside of the envelope of the mobile platform using an external antenna for communication with the ground.

A bus bar (electrode) is formed around the perimeter of the RF shielding layer applied to the window. The bus bar is electrically conductive and is grounded to the outer envelope of the mobile platform through an electrically conductive element. The bus bar is typically formed of a thick, non-transparent, layer of metal that forms a ring around the transparent conductive layer. The bus bar serves as an electrical contact point for grounding the transparent conductive layer. The grounding element can be conductive metal straps or cables, or preferably the metal clips that are commonly used to hold the windows in place. In a preferred embodiment, several equally spaced grounding straps or clips around the perimeter of the window shield are used.

Further areas of applicability of the present invention will become apparent from the detailed description provided hereinafter. it should be understood that the detailed description and specific examples are intended for purposes of illustration only and are not intended to limit the scope of the invention.

### BRIEF DESCRIPTION OF THE DRAWINGS

The present invention will become more fully understood from the detailed description and the accompanying drawings, wherein:
Figure 1 is a side elevational view of an aircraft having the wireless communication system of the present invention;
Figure 2 is an elevational view similar to Figure 1 identifying wireless device use according to a preferred embodiment of the present invention;
Figure 3 is a partial cross sectional view taken at Section 3 of Figure 2 showing an exemplary aircraft window assembly incorporating a preferred embodiment conductive coating of the present invention;
Figure 4 is an elevational view of an exemplary window of a mobile platform showing the transparent conductive film and bus bar of the present invention disposed thereon;
Figure 5 is an elevational side view of the window of Figure 4, identifying an exemplary procedure for installing a layer of transparent conductive film of the present invention;
Figure 6 is a partial cross sectional view similar to Figure 3, showing the addition of grounding straps in another preferred embodiment of the present invention; and
Figure 7 is a block diagram showing the steps to control wireless device transmission according to a preferred embodiment of the present invention.

### DETAILED DESCRIPTION OF THE PREFERRED EMBODIMENTS

The following description of the preferred embodiments is merely exemplary in nature and is in no way intended to limit the invention, its application, or uses.

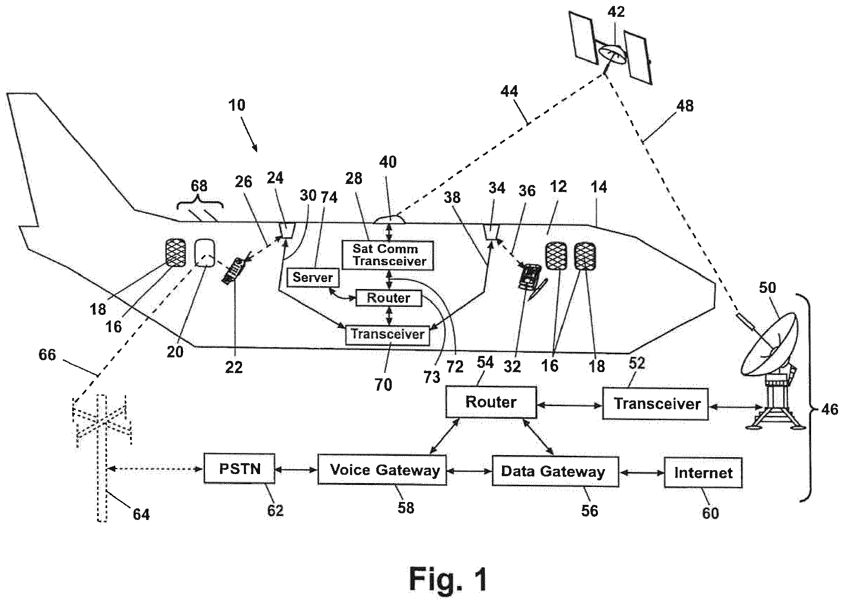

Referring to Figure 1, a wireless communication system 10 according to a preferred embodiment of the present invention is shown. An exemplary aircraft 12 includes a fuselage 14 and a plurality of windows 16 disposed in the fuselage 14. Each of the windows 16 includes a conductive film 18 disposed over at least one surface thereof. An unshielded window 20, lacking a conductive film 18, is shown for discussion in further detail below.

One or more wireless cellular devices 22 are wirelessly linked to one or more picocell antennas 24 via a radio frequency (RF) signal path 26. In the preferred embodiment, the picocell antenna(s) 24 are each connected to one of a plurality of picocell/gateway transceivers 70 via an RF line 30. Similarly, one or more passenger wireless network devices 32 are connected to one or more wireless network gateway antennas 34 via a wireless data line 36. The wireless network gateway antennas 34 are each connected to the picocell/gateway transceivers 70 via an RF line 38. A satellite communication transceiver (Sat Comm Transceiver) 28 is in communication with an antenna 40, mounted on the outside of the fuselage 14, for wirelessly conveying RF signals to/from each of the wireless cellular devices 22 and the wireless network devices 32, and a satellite 42, via an antenna-to-satellite path 44.

The satellite 42 is in wireless communication with a ground station 46 via a satellite-to-ground signal path 48. The ground station 46 includes a ground-based antenna 50 in communication with a transceiver 52, which relays signals to/from the ground-based antenna 50 and a signal router 54. The signal router 54 splits signals between data signals and voice communication signals, forwarding data signals to a data gateway 56, and forwarding voice communication signals to a voice gateway 58. At the data gateway 56, data signals are further transmitted or received to/from the Internet 60. At the voice gateway 58, voice communication signals are further transmitted or received to/from a public switched telephone network (PSTN) 62. Two-way traffic from the wireless cellular device(s) 22 and the wireless network device(s) 32 to the ground station 46 is thereby provided. The path from the antenna 40 to the ground station 46, which includes the antenna-to-satellite path 44, the satellite 42, the satellite-to-ground signal path 48, and the ground-based antenna 50 is a preferred path for wireless signal communication between the aircraft 12 and the ground station 46. Installation of the conductive film 18 sufficiently attenuates the signal strength between cellular device 22 within aircraft 12 and an exemplary terrestrial cellular phone tower/base station 64, along a wireless communication path 66, to disable all communication along the communication path 66.

According to the preferred embodiment of the present invention, at least one picocell antenna 24 is disposed within the fuselage 14 of the aircraft 12. Electromagnetic radiation from the wireless cellular device 22, which is blocked by the conductive film 18 disposed over each of the windows 16 and 20, is wirelessly transmitted to the picocell antenna 24 via radio frequency (RF) signal path 26. Picocell antenna 24 is a remote antenna with an RF transmission line interface to the one or more transceivers 70 wherein the RF signal is processed into a digital signal. In the preferred embodiment: each picocell antenna 24 communicates with transceiver 70 via RF line 30 for subsequent transmission via a router 73, satellite communication transceiver 28 and antenna 40 to the satellite 42. Router 73 only accepts in-coming packets addressed to aircraft 12 and multiplexes outgoing packets into a single data stream. A server 74 controls the wireless access to picocell antennas 24 and wireless network gateway antennas 34. Data transmission signals from the wireless network devices 32 are received by one of the wireless network gateway antennas 34 (also commonly referred to as access points) disposed within the fuselage 14 of the aircraft 12. Similar to the picocell antennas 24, a plurality of wireless network gateway antennas 34 can be used. The picocell antennas 24 and network gateway antennas 34 act as "transceiver hubs", collecting wireless signals.

In an alternate embodiment, (not shown), picocell antenna 24 incorporates an RF transceiver, modem and a signal processor, and the interface to transceiver 70 is digital. In this alternate embodiment, the picocell antenna 24 can be directly connected to router 73. In another alternate embodiment, the picocell/gateway transceivers 70 and the picocell antenna(s) 24 are combined into a single unit (not shown) which is in communication with router 73 via one or more data lines (not shown). Additionally, the picocell/gateway transceivers 70 and the wireless network gateway antennas 34 are also combined into a single unit (not shown) which is in communication with router 73 via one or more data lines (not shown).

By incorporating both the picocell antennas 24 and the wireless network gateway antennas 34 of the present invention and disposing the conductive film 18 over each of the windows 16 and 20, wireless devices operated within the aircraft 12 can only achieve connectivity outside of the aircraft 12 by accessing either picocell antennas 24 for telephony, or wireless network gateway antennas 34, using radio frequency signal path 26 and wireless data line 36, respectively. Any wireless device inside (inboard) the aircraft 12 that is not able to access picocell antennas 24 or wireless network gateway antennas 34 will not be able to achieve connectivity outside (outboard) the aircraft 12 because of the RF shielding provided by conductive film 18. The communication path 66 is blocked to all wireless cellular devices 22 and all wireless network devices 32 by the RF shielding provided by conductive film 18. The wireless communication system 10 of the present invention also reduces the amplitude of electromagnetic radiation escaping from fuselage 14 due to emissions from wireless cellular devices 22 or wireless network devices 32 that penetrate windows 16 and follow a propagation path along the skin of the conductive fuselage 14 to impinge on a plurality of safety critical navigation and communication system antennas 68 (used for navigation and communication) that are mounted on the outside surface of fuselage 14. This radiation can potentially interfere with flight operations of aircraft 12.

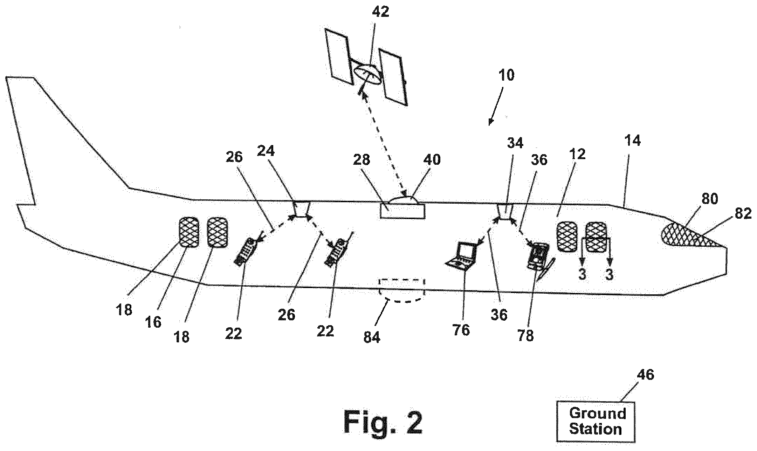

As best seen in Figure 2, each of the picocell antennas 24 and the wireless network gateway antennas 34 are sized to accommodate one or more wireless devices. The number of the picocell antennas 24 and the wireless network gateway antennas 34 to be installed will depend on several factors including: the size of the aircraft 12, the geometry of the fuselage 14, the anticipated number of wireless devices to be operated during use of the aircraft 12, and other factors including expected power output of each wireless device, operating frequency for each wireless device, and proximity of the wireless devices to each of the picocell antennas 24 and the wireless network gateway antennas 34. An exemplary pair of the wireless cellular devices 22 are shown. Exemplary wireless network devices 32 shown include a wireless laptop computer 76 and a personal electronic device, such as a personal digital assistant 78.

Figure 2 also shows at least one cockpit window 80 disposed in the aircraft 12. Each cockpit window 80 is commonly provided with a conductive film 82 which permits deicing and defogging of the cockpit window 80. On aircraft which are not equipped with the deicing capability of the conductive film 82, a conductive film 18 and a grounding method of the present invention can be disposed on each of the cockpit windows 80.

Figure 2 shows a preferred embodiment having communication paths utilizing the antenna 40, the satellite 42, and the ground station 46. It should be obvious that the satellite 42 and the ground station 46 are exemplary of devices disposed in the communication path between the aircraft 12 and any ground based communication terminal. A further embodiment of the invention uses direct communication between an external antenna 84 and the ground station 46. For this approach (shown in phantom), the external antenna 84 is preferably mounted at the base of the fuselage 14 where it has an unobstructed communication path to ground station 46.

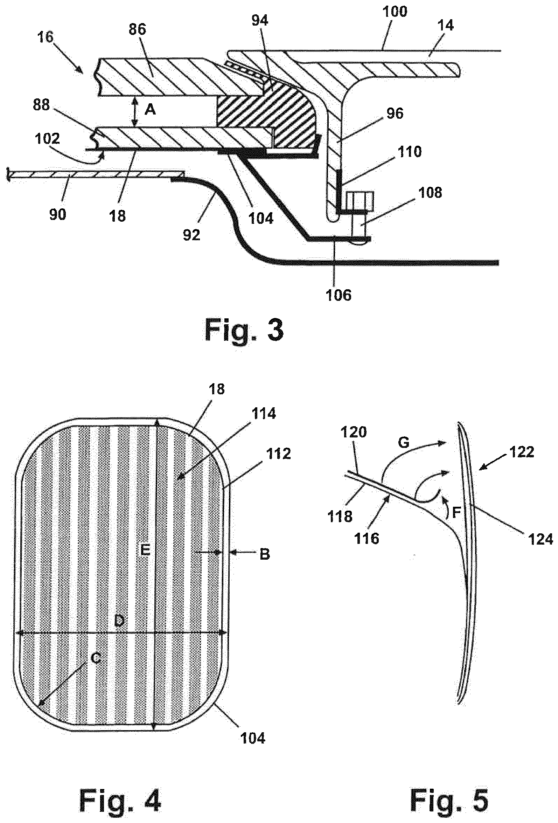

As best seen in Figure 3, a common commercial aircraft configuration for the window 16 is shown in cross section, where the window 16, (shown as an assembly), meets the window opening in fuselage 14 of aircraft 12. The window 16 includes an external pane 86, an internal pane 88, and a protective pane 90 that is part of a cabin wall 92. The protective pane 90 is typically provided on the passenger side of the fuselage of the aircraft. A seal 94 is an integral part of window assembly 16 and is used to join the internal pane 88 and external pane 86 and to prevent pressurized cabin atmosphere from escaping through the interface between window 16 and a window forging 96, which is attached to fuselage 14. Window panes 86 and 88 are typically formed of plastic, however, window pane material can also be glass or composites of a variety of materials. As the aircraft increases in operating altitude, internal pressure of the aircraft exceeds external pressure, and the window 16 typically displaces outward, which compresses seal 94 to prevent internal atmosphere from escaping.

Common commercial aircraft include the cabin wall 92, typically made of a plastic material, disposed along the passenger facing interior envelope of the aircraft. The protective pane 90 is connectably disposed to the cabin wall 92. An exterior skin 100 of fuselage 14 is structurally reinforced at the window openings by the plurality of window forgings 96 that are inserted into the window openings. The exterior skin 100 and the window forgings 96 are typically formed of metal materials which are electrically conductive. An alternate carbon fiber exterior skin 100 of aircraft 12, employing composite materials, is also electrically conductive and provides significant RF shielding capability. With the exception of the windows 16, the entire fuselage 14 of most commercial aircraft is therefore electrically conductive and forms a barrier to wireless electromagnetic radiation penetrating the exterior skin 100 of an aircraft. According to the present invention, the conductive film 18 is disposed along at least one of the external pane 86 and/or the internal pane 88 of each window 16. In the preferred embodiment shown in Figure 3, the conductive film 18 is disposed on an interior facing side 102 of the internal pane 88 of window 16. An electrically conductive bus bar 104 is disposed about a perimeter of the internal pane 88 and in electrical contact with the conductive film 18. A clip 106 is biased into contact with the bus bar 104 and fixed to the window forging 96 via a fastener 108 and a bracket 110. The clip 106, the fastener 108, and the bracket 110 are selected from electrically conductive materials, such as metals, such that electromagnetic radiation which contacts the conductive film 18 is grounded via the bus bar 104, the clip 106, the fastener 108 and the bracket 110 to the window forging 96 and the skin 100 of fuselage 14.

The conductive film 18 grounds the surface area of each of the windows 16 to the exterior skin 100 of the aircraft. This forms a Faraday cage within the fuselage of the aircraft in which electromagnetic energy can neither enter or escape from the fuselage 14. Electromagnetic radiation from wireless communication devices within the aircraft is blocked at each of the windows 16 by the conductive film 18. In one preferred embodiment of the present invention, individual clips 106 are used and intermittently spaced about the perimeter of each of the windows 16 making contact with bus bar 104. On common commercial aircraft, approximately 10 clips 106 are employed to mount each of the windows 16 to the window forging 96. The clips 106 put pressure on the window 16 to hold it against window forging 96 which provides good electrical contact to bus bar 104. The clips 106 maintain contact with the bus bar 104 as the window 16 is pressed into the window forging 96 by increasing differential cabin pressure. Thus, spring loading of the clips 106 assures good electrical contact with bus bar 104 as the aircraft 12 varies altitude.

Referring next to Figure 4, an exemplary internal pane 88 of window 16 is shown having the conductive film 18 disposed on a surface thereof. The conductive film 18 includes a plastic, semi-transparent film 112 having a thin conductive coating 114 formed thereon. The conductive coating 114 is typically formed of metal or metal oxide. Gold or silver are commonly used. An exemplary semi-transparent film 112 is manufactured by CP Films, Incorporated, of Martinsville, VA. The CP Films, Incorporated conductive film is disposed on a plastic polymer substrate. A gold film is disposed thereon and a heat stabilized clear hard coated film coated thereover. The CP Films, Incorporated conductive film has a visible light transmittance of approximately 75% or greater, with a surface resistance ranging from approximately 4.5 to 10 ohms per square inch.

In a preferred embodiment, the bus bar 104 is formed together with the conductive film 18 and applied as an appliqué. The conductive film 18 and the bus bar 104 can also be formed by silk screening, sputtering or evaporation. The bus bar 104 is typically formed of metal that is thicker than that used for the transparent conductive portion of the conductive film 18. Hence, the bus bar 104 is opaque and has much lower electrical resistance than the semitransparent conductive film. The bus bar 104 does not block or compromise the optical qualities of the window 16 because it is placed around its periphery. The bus bar 104 is applied to the same surface of the polymer conductive film 18 on which the semitransparent conductive coating is applied. This enables excellent electrical contact between the semitransparent conductive surface and the bus bar 104. Adhesive (not shown) is applied to the surface of the conductive film 18 that is opposite to the side having the bus bar 104.

The exemplary internal pane 88 is shown having a bus bar width "B" of 0.6 cm (0.25 in), a window corner radius "C" of 9.9 cm (3.9 in), a window width "D" of 28.7 cm (11.3 in), and a window height "E" of 38.9 cm (15.3 in). It should be obvious that these dimensions are exemplary of a variety of window dimensions available for aircraft or any mobile platform use.

As best seen in Figure 5, the preferred embodiment of the present invention uses a window appliqué 116 that is formed of a conductively coated polymer sheet 118 with integral bus bar (not shown) and adhesive backing. A protective backing 120 is used to cover the adhesive surface of the window appliqué 116. The window appliqué 116 is applied to a window 122 by peeling off the protective backing 120 in the direction of arrow "F" and pressing the adhesive surface against the window, in the direction of arrow "G", being careful to avoid air pockets or bubbles. Installation of window appliqué 116 on an internal pane 124 of window 122 is demonstrated. The polymer sheet 118 has an adhesive backing (not shown) which adheres to the internal pane 124 as the polymer sheet 118 is pressed in the installation direction "G" onto the internal pane 124.

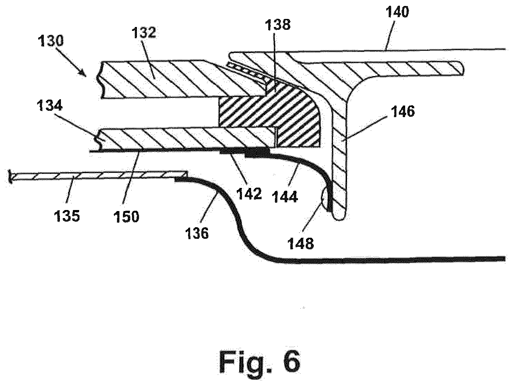

As best shown in Figure 6, an alternate embodiment of the present invention provides a window assembly 130 having an external pane 132, an internal pane 134 and a protective pane 135 that is part of a wall panel 136. A seal 138 is disposed between the external pane 132, the internal pane 134, and an exterior skin 140 of a mobile platform. At least one bus bar 142 is disposed about the perimeter of the internal pane 134. In the embodiment shown in Figure 6, a clip may or may not be used to hold the window assembly 130 in place. In this embodiment, the clips do not provide a grounding path to the fuselage. Instead, one or more grounding straps 144 are disposed between each bus bar 142 and the exterior skin 140 or window forging 146. Each grounding strap 144 is connected using a fastener 148. A semi-transparent conductive film coating 150 is disposed on the internal pane 134 and electrically connected to the bus bar 142.

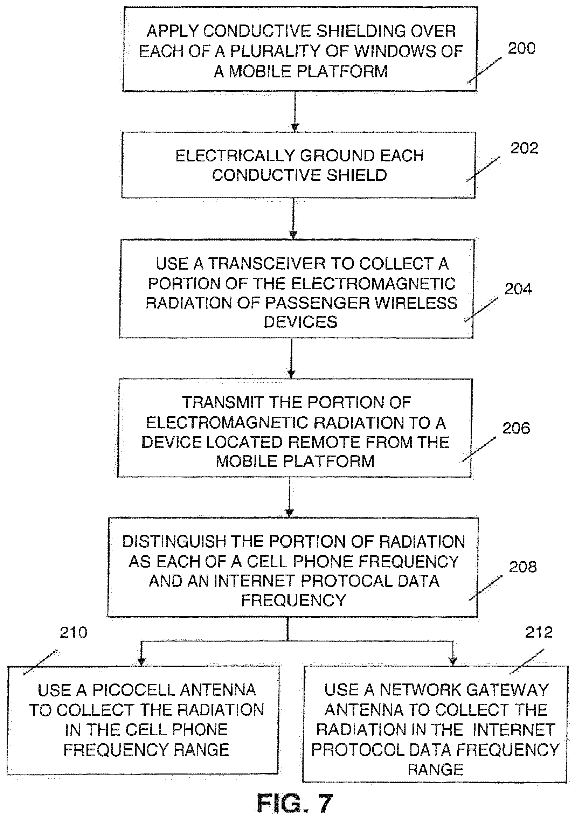

Referring to Figure 7, the steps to control wireless device transmission within a mobile platform include in a step 200, applying a conductive shielding over each of a plurality of windows of a mobile platform. At step 202, each conductive shield is electrically grounded to the mobile platform. Following in step 204, a transceiver is used to collect a portion of the electromagnetic radiation from passenger wireless devices onboard the mobile platform. In step 206, the portion of electromagnetic radiation is transmitted to a device located remote from the mobile platform. In an additional step 208, the portion of radiation is distinguished as each of a cell phone frequency range and an Internet protocol data wireless access point frequency range. In a first parallel step 210, a picocell antenna is used to collect radiation generated in the cell phone frequency range. In a second parallel step 212, a network gateway antenna is used to collect radiation generated in the Internet protocol data wireless access point frequency range.

The wireless communication system of the present invention offers several advantages. Direct communication between the wireless communication devices and base stations external to the mobile platform can be prevented by blocking RF signals from entering or existing the aircraft fuselage using conductive films disposed over each of the windows of the mobile platform. This prevents the wireless communication devices used on the aircraft from directly accessing a plurality of terrestrial cellular base stations and network gateways, for instance while an aircraft is at flight elevation. The wireless communication system of the present invention provides internal picocells and/or wireless network gateways for wireless communication with passenger operated wireless devices. The close proximity of the picocells and network gateways to the wireless passenger devices within the aircraft cabin enables these devices to communicate at very low power levels, further reducing the potential for interference with flight critical aircraft electronics. Many wireless devices such as cellular phones automatically adjust their transmit power to the minimum necessary to establish and maintain communication with the picocell. Placing the picocell inside the aircraft cabin in close proximity to the passenger cellular phones leads to a large reduction of transmit power levels (typically orders of magnitude) compared to the power levels that the cell phone would require to establish direct communications with a terrestrial cellular base station from within a typical aircraft that is not equipped with the RF window shielding of this invention. Thus, the on-board picocell of this invention effectively reduces the aggregate RF power density within the fuselage of the aircraft. This reduces the perceived negative health effects of RF radiation within the aircraft cabin and reduces interference with flight critical aircraft electronics.

Typical ceiiuiar phones can emit 500 mW or more of power when they must communicate over the long distances that are typical between an aircraft at cruise altitude and a terrestrial base station and when they incur signal losses during propagation through the fuselage and unshielded window openings. In contrast, the invention permits both the passenger wireless devices and the picocells/gateways to operate at very low power, i.e., 10 mW or less. By blocking the radiation pathway through the windows of a mobile platform using the conductive film of the present invention, electromagnetic radiation from wireless devices within the mobile platform cannot escape through the window and cause interference with the externally mounted antennas of the mobile platform. This forces passenger wireless devices to connect to the on-board picocells/gateways, or, if the on-board picocells/gateways do not support their communication standard, the devices will be disabled from operating by the high attenuation of the shielded aircraft windows of the invention. Most cellular phones will enter a hybernation mode when they are not able to communicate with a cellular base station (either on-board the aircraft or off-board the aircraft).

By using picocell antennas, a service range of approximately one hundred meters or less is provided which is adequate for operation within the enclosed spaces of a typical mobile platform. Use of multiple picocell antennas and/or wireless network gateways also provides operational access by a wireless device located anywhere within the mobile platform to access the antenna of the mobile platform. The wireless communication system 10 of the present invention is operable within a frequency range between approximately 100 kHz up to approximately 100 gHz.

Common wireless telephone systems in use today are designed for a maximum of approximately 30 decibel (dB) environmental losses between the base station 64 and the wireless cellular device 22 due to multi-path fading, object penetration (buildings, etc.), etc. Cellular systems are designed to operate with a maximum range of several miles between the cellular base station and the handset, even with the additional 30 dB environmental losses described above. Therefore, 30 dB of window shielding attenuation may not be sufficient for disabling communication between terrestrial base stations and aircraft passenger cellular phones when the aircraft is on the ground, especially when the cellular tower is located in close proximity to the aircraft, as they often are at airports. However, once the aircraft reaches cruise altitude there is typically several miles of range to the terrestrial base station such that the 30 dB of window shielding attenuation is sufficient to disable communications with the ground.

The conductive film of the present invention introduces approximately 30 dB or more of RF signal attenuation to effectively block the electromagnetic radiation generated by the wireless cellular device at the window of a mobile platform. Conductive films which produce less than or greater than 30 dB attenuation can also be used in a wireless communication system of the present invention. A conductive film of the present invention can also be disposed within a laminated window, i.e., a multi-pane window constructed with an intermediate layer of conductive film in contact with adjoining panes of the window. In a further embodiment of the present invention, one or more grounding straps (i.e., item 144 shown in Figure 6) can be used to supplement the clips 106 shown in Figure 3. Wireless devices compatible with the system of the present invention include wireless telephones and other wireless cellular devices; wireless data transmission devices, including laptop computers and electronic notepads; wireless access points; Wi-Fi portable devices; etc.

An additional network security benefit is also provided by the invention because outside intruders using wireless devices are less able to gain access to the wireless infrastructure inside the aircraft fuselage because of the RF isolation provided by the shielded windows.

Further, the current disclosure comprises embodiments according to the following clauses:
Clause 1: A system to limit the transmission of electromagnetic radiation through one or more windows penetrating an outer envelope of a mobile platform, the electromagnetic radiation being generated by wireless devices located within the outer envelope, said system comprising:
   an electromagnetic radiation shielding layer applied to said window and electrically grounded to said outer envelope;
   at least one wireless transceiver hub located within the outer envelope in wireless communication with the wireless devices; and
   an off-board communication device located remote from the outer envelope in wireless communication with said transceiver hub;
   wherein said shielding layer operably attenuates the electromagnetic radiation such that a communication path between the mobile platform and said off-board communication device is operable only between said transceiver hub and said off-board communication device.
Clause 2: The system of clause 1, comprising an outer envelope mounted antenna in communication with each said transceiver hub, for wirelessly linking each said transceiver hub and said off-board communication device.
Clause 3: The system of clause 1 or 2, wherein each said wireless transceiver hub comprises a picocell base station for communication with a plurality of wireless telephone handsets. Clause 4: The system of any of clauses 1 to 3, wherein said off-board communication device comprises one of a satellite and a ground-based communication terminal.
Clause 5: The system of any of clauses 1 to 4, further comprising:
   a transceiver in communication with each said transceiver hub;
   a router in communication with said transceiver; and
      an antenna mounted on an outside of said envelope; and
      a communication transceiver in communication between said router and said antenna.
Clause 6: The system of any of clauses 1 to 5, wherein said shielding layer comprises a semi-transparent, metal-based film, preferably having an adhesive layer for installation on said window.
Clause 7: The system of any of clauses 1 to 6, wherein said window comprises a plurality of panes, and said shielding layer operably forming a conductive coating when applied to a surface of at least one of said panes.
Clause 8: The system of any of clauses 1 to 7, wherein said window comprises a plurality of panes, and said shielding layer operably forming a conductive interlayer when disposed adjacent to one of said panes.
Clause 9: The system of any of clauses 1 to 8, further comprising at least one electrically conductive member electrically joining said shielding layer to said envelope of said mobile platform.
Clause 10: The system of any of clauses 1 to 9, wherein said shielding layer comprises at least one busbar for electrically connecting said shielding layer to said envelope.
Clause 11:A method to control electromagnetic radiation associated with passenger wireless devices on a mobile platform, comprising the steps of:
   applying a conductive shield over each of a plurality of windows of said mobile platform;
   electrically grounding each conductive shield;
   using a transceiver hub positioned within said mobile platform to collect a portion of the electromagnetic radiation; and
   transmitting said portion of said electromagnetic radiation to a device located remote from said mobile platform.
Clause 12:The method of clause 11, comprising distinguishing said portion of said radiation between each of a cell phone frequency range and an Internet protocol data wireless access point frequency range.

The description of the invention is merely exemplary in nature and, thus, variations that do not depart from the gist of the invention are intended to be within the scope of the invention. Such variations are not to be regarded as a departure from the spirit and scope of the invention.

## Claims

1. A system to limit the transmission of electromagnetic radiation (66) through one or more windows (16, 20, 80; 122; 130) penetrating an outer envelope (14) of a mobile platform (12), the electromagnetic radiation (66) being generated by wireless devices (22, 32) located within the outer envelope (14), said system comprising:
an electromagnetic radiation shielding layer (18; 114; 150) applied to said window (16, 20, 80; 122, 130) and electrically grounded to said outer envelope (14); the system being **characterized by**
a plurality of wireless transceiver hubs (24, 34) located within the outer envelope (14) in wireless communication with the wireless devices (22, 32);
an off-board communication device (46) located remote from the outer envelope (14) in wireless communication with each of said transceiver hubs (24, 34); an outer envelope mounted antenna (40) in communication with each transceiver hub (24, 34) via a transceiver (70), a router (72) and a communication transceiver (28), for wirelessly linking each transceiver hub (24, 34) and said off-board communication device (46);
said transceiver (70) in communication with each said transceiver hub (24, 34);
said router (72) in communication with said transceiver (70); and
said communication transceiver (28) in communication between said router (72) and said antenna (40); wherein the electromagnetic radiation shielding layer (18; 114; 150) comprises a conductive coating (114) formed on a plastic, semi-transparent film (112); and wherein a bus bar (104) which is electrically conductive and grounded to the outer envelope (14) through an electrically conductive element is formed around the perimeter of the electromagnetic radiation shielding layer (18; 114; 150).

2. The system of claim 1, wherein said off-board communication device (46) comprises one of a satellite (42) and a ground-based communication terminal (50).
